(19) Europäisches Patentamt — European Patent Office — Office européen des brevets

(11) **EP 2 637 197 B1**

(12) **FASCICULE DE BREVET EUROPEEN**

(45) Date de publication et mention de la délivrance du brevet:
**19.05.2021 Bulletin 2021/20**

(51) Int Cl.:
***H01L 21/18*** *(2006.01)*     *H01L 23/29* *(2006.01)*
***H01L 23/00*** *(2006.01)*

(21) Numéro de dépôt: **13157688.6**

(22) Date de dépôt: **04.03.2013**

(54) **PROCÉDÉ DE COLLAGE DIRECT UTILISANT UNE COUCHE POREUSE COMPRESSIBLE**

DIREKTES BINDUNGSVERFAHREN UNTER VERWENDUNG EINER PORÖSE VERDICHTBAREN SCHICHT

DIRECT BONDING PROCESS USING A COMPRESSIBLE POROUS LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.03.2012 FR 1251988**

(43) Date de publication de la demande:
**11.09.2013 Bulletin 2013/37**

(73) Titulaire: **Commissariat à l'Énergie Atomique et aux Énergies Alternatives 75015 Paris (FR)**

(72) Inventeur: **Leduc, Patrick 38000 GRENOBLE (FR)**

(74) Mandataire: **Ilgart, Jean-Christophe et al BREVALEX 95, rue d'Amsterdam 75378 Paris Cedex 8 (FR)**

(56) Documents cités:
**EP-A1- 0 553 774    EP-A1- 0 554 795**
**EP-A2- 0 851 513    EP-A2- 2 154 710**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

L'invention concerne un procédé de collage direct entre deux éléments, comprenant la réalisation d'une couche poreuse compressible pour réduire la taille des défauts générés à l'interface de collage entre les deux éléments. Un tel procédé est avantageusement mis en œuvre pour réaliser un collage direct entre deux substrats, ou entre deux puces (ou circuits) électroniques, ou encore entre un substrat et une puce électronique.

**ÉTAT DE LA TECHNIQUE ANTÉRIEURE**

La réalisation d'un collage direct entre deux éléments consiste à mettre en contact direct deux surfaces de ces éléments, sans utiliser de matériau d'adhérence spécifique (colle, cire, métal à basse température de fusion pour former une soudure, etc.) entre ces deux surfaces. Un tel collage nécessite que les deux surfaces à coller soient suffisamment lisses, exemptes de particules ou de contamination (en particulier par des hydrocarbures), et qu'elles soient suffisamment proches l'une de l'autre pour permettre d'initier un contact, typiquement à une distance inférieure à quelques nanomètres. Dans ce cas, les forces attractives entre les deux surfaces deviennent assez élevées pour provoquer une adhérence moléculaire entre les surfaces.

Le collage direct est induit initialement par l'ensemble des forces attractives (forces de Van der Waals) d'interaction électronique entre atomes ou molécules des deux surfaces à coller. Ces forces attractives sont d'autant plus importantes que la distance entre les atomes ou molécules des deux surfaces est faible. En outre, elles dépendent de la nature des surfaces et du milieu qui les sépare. Pour la plupart des collages directs, on est ainsi amené à considérer deux familles de surfaces : les surfaces présentant un caractère hydrophile et celles présentant un caractère hydrophobe. La différence principale existant entre ces deux types de surface est la présence de films d'eau (correspondant à quelques monocouches moléculaires) adsorbée par les surfaces hydrophiles.

Dans de nombreuses applications, les collages sont réalisés à température et à pression ambiantes, après avoir réalisé un nettoyage chimique des surfaces à coller. L'énergie de collage obtenue peut être améliorée par la mise en œuvre d'un traitement thermique. Plus la température mise en jeu lors de ce traitement thermique est haute, plus l'énergie de collage obtenue est importante. Au-delà d'une certaine température, qui dépend en particulier du nettoyage réalisé avant le collage des surfaces (hydrophiles ou hydrophobes), la majorité des liaisons entre les deux surfaces deviennent des liaisons covalentes.

Un tel collage direct peut être réalisé entre deux substrats de semi-conducteur. Un collage direct peut également être réalisé entre deux puces électroniques comportant chacune des plots de connexion métalliques, les puces étant collées l'une à l'autre telles que les plots de connexion métalliques des puces qui se trouvent en regard les uns des autres soient reliés ensemble électriquement, formant des interconnexions électriques entre les deux puces (cas d'une intégration dite « 3D » des puces). Dans ce cas, le scellement réalisé correspond à un collage mixte de métal (cuivre, nickel, ...) des plots de connexion et de diélectrique, par exemple de l'oxyde de silicium, se trouvant entre les plots de connexion.

Une difficulté liée à la réalisation d'un tel collage direct réside principalement dans la préparation des surfaces à coller qui est réalisée afin d'enlever le plus de particules et de contaminants présents sur ces surfaces. En effet, une particule de quelques centaines de nanomètres de diamètre présente sur l'une des surfaces à coller peut générer, au niveau de l'interface de collage, un défaut (qui correspond à une zone non collée entre les surfaces, autour de la particule) de plusieurs mm$^2$. Pour cette raison, le plus grand nombre possible de particules doivent être retirées lors de la préparation des surfaces avant collage. Un polissage mécano-chimique (CMP) suivi d'un nettoyage par brossage (« scrubber ») et chimique sont généralement mis en œuvre pour retirer les particules présentes sur les surfaces à coller.

Toutefois, pour certaines applications telles que l'intégration 3D de puces électroniques, cette contrainte de nettoyage rend difficile l'utilisation du collage direct. Par exemple, pour le collage direct entre une puce et un substrat comportant chacun des plots de cuivre destinés à être collés directement les uns contre les autres, le retrait des particules peut être rendu difficile soit par la présence de topographies en surface (dues aux plots), soit par la présence de matériaux hétérogènes sur les surfaces, soit encore par la gestion de la préparation de surfaces des puces. De plus, il n'est jamais possible d'obtenir des surfaces qui soient parfaitement propres et exemptes de particules.

Le document de Y. Bertholet et al., « Molecular bonding aided by dissipative inter-layers », Acta Materiala, Volume 55, Issue 2, janvier 2007, pages 473-479, décrit la possibilité d'insérer une fine couche déformable plastiquement composée d'aluminium entre un substrat et une couche de collage de SiO$_2$ lors d'un collage direct avec un autre substrat qui comporte également une fine couche déformable plastiquement composée d'aluminium insérée entre cet autre substrat et une autre couche de collage de SiO$_2$.

La présence de ces couches d'aluminium permet d'augmenter la résistance de l'ensemble réalisé par rapport à la création et à la propagation de fissures au niveau de l'interface de collage, et donc d'améliorer l'adhérence au niveau de l'interface de collage. Cette amélioration de l'adhérence est liée à la relaxation, ou dissipation, de l'énergie mécanique dans les couches déformables, au voisinage des fissures, grâce à la déformation plastique de ces couches. Dans ce document, les couches déformables plastiquement d'aluminium ont une épaisseur égale à 1 μm.

Toutefois, de telles couches déformables plastiquement ne permettent pas de répondre efficacement au problème lié à la présence de particules à l'interface de collage du fait qu'en présence de telles particules au niveau de l'interface de collage, ces couches ne se déforment localement que de façon très limitée, la matière déformée plastiquement par la particule étant déplacée en outre en périphérie de celle-ci

Les documents EP 0 554 795 A1 , EP 0 553 774 A1, EP 0 851 513 A2 et EP 2 154 710 A2 divulguent des couches poreuses en proximité de l'interface de collage.

## EXPOSÉ DE L'INVENTION

Il existe donc un besoin de proposer un procédé de collage direct entre deux éléments permettant de réduire la taille des défauts engendrés par la présence de particules au niveau des surfaces des éléments destinées à être solidarisées l'une contre l'autre.

Pour cela, un mode de réalisation propose un procédé de collage direct entre un premier élément et un deuxième élément, comportant au moins les étapes de :

- réalisation d'au moins une première couche poreuse sur au moins une face du premier élément, la première couche poreuse étant compressible et présentant un coefficient de compressibilité isotherme $\chi_T$ supérieur à $10^{-10}$ Pa$^{-1}$ à 25°C,
- réalisation d'au moins une première couche de collage sur la première couche poreuse,
- solidarisation par collage direct du deuxième élément avec la première couche de collage.

On entend par couche « compressible » une couche de matériau dont le volume diminue sous l'effet d'une contrainte de pression par rapport à son volume initial, c'est-à-dire par rapport à son volume lorsque la couche n'est pas soumise à une contrainte de pression. Cette compressibilité de la couche poreuse est obtenue grâce à la présence des pores dans la couche et aux propriétés d'élasticité et/ou de plasticité intrinsèques du matériau de la couche poreuse. Ainsi, ce caractère compressible de la couche poreuse permet d'avoir une réduction du volume de la couche en présence d'une pression mécanique correspondant à celle générée par une ou plusieurs particules présentes à l'interface de collage lors du collage direct entre les deux éléments.

Ainsi, en utilisant une couche poreuse et compressible, lors de l'insertion d'une ou plusieurs particules directement ou indirectement dans la couche poreuse (les déformations engendrées par les particules étant transmises dans la couche poreuse), le matériau de la couche poreuse se déforme localement par densification de sa structure, sans déplacement de la matière vers l'extérieur de la zone indentée par chaque particule.

Le procédé de collage direct propose donc d'insérer une couche poreuse dans la partie supérieure du premier élément, sous la surface destinée à être assemblée par collage direct au deuxième élément. Compte tenu de la présence des pores, ou porosités, dans cette couche et ses propriétés mécaniques, celle-ci est donc compressible. Cette couche poreuse peut être compressible élastiquement (c'est-à-dire déformable élastiquement) et/ou compressible plastiquement (c'est-à-dire déformable plastiquement). Une contrainte mécanique en compression appliquée sur la couche poreuse engendre donc une réduction de son volume et une densification de sa structure. Cette couche poreuse permet d'absorber tout ou partie des déformations dues, lors de la solidarisation par collage direct, à la présence de particules sur les surfaces à coller. Dans le cas d'une couche poreuse composée d'un matériau compressible élastiquement, le caractère compressible de la couche poreuse est dû à la combinaison de la nature élastique du matériau utilisé (un matériau dont le module d'Young peut être inférieur ou égal à environ 20 GPa comporte par exemple une capacité de déformation élastique élevée) et de la présence de porosités dans cette couche dont le volume peu diminuer localement afin de compenser, ou « absorber », le volume des particules présentes à l'interface de collage. Dans le cas d'une couche poreuse composée d'un matériau compressible plastiquement, le caractère compressible de la couche poreuse est dû à la combinaison de la nature déformable du matériau utilisé (qui a par exemple une limite d'élasticité inférieure ou égale à environ 350 MPa) et de la présence de porosités dans cette couche.

La présence d'une telle couche poreuse rend le collage direct pas ou peu sensible aux particules éventuellement présentes sur les surfaces à coller, ce qui permet une réduction très importante de la taille des défauts de collage dus à la présence de particules, c'est-à-dire la taille des zones non collées autour des particules. Lors de la mise en contact des deux surfaces à solidariser, la couche poreuse se déforme localement au voisinage des particules, ce qui facilite la mise en contact des deux surfaces à coller et, par conséquent, réduit la taille des zones non collées, c'est-à-dire des défauts.

La première couche poreuse peut être réalisée via la mise en œuvre d'une étape de dépôt. Ainsi, il est possible de réaliser la couche poreuse sans contrainte vis-à-vis de la nature du matériau sur lequel la couche poreuse est déposée (correspondant au premier élément). Ainsi, il est possible de réaliser la couche poreuse sur un élément qui n'est par exemple pas du silicium. La couche poreuse peut donc comporter au moins un matériau différent de celui du premier élément. De plus, la réalisation de la couche poreuse via la mise en œuvre d'un dépôt permet de former la couche poreuse sans avoir nécessairement un fond continu conducteur pour la réalisation des porosités. La couche poreuse peut donc être réalisée sur une surface électriquement isolante.

La couche poreuse compressible présente un coefficient de compressibilité isotherme $\chi_T$ supérieur à environ $10^{-10}$ Pa$^{-1}$ à environ 25°C.

La compressibilité d'un matériau correspond à la réduction de volume du matériau lorsqu'il est soumis à une compression isostatique (ou uniforme). Elle est généralement définie dans le domaine élastique, donc réversible. Cependant, cette définition peut être étendue au domaine inélastique. Le coefficient de compressibilité isotherme $\chi_T$ d'un matériau isotrope est défini selon l'équation suivante :

$$\chi_T = -\frac{1}{V}\left(\frac{\delta V}{\delta P}\right)_T$$

V étant le volume du matériau, P la pression isostatique, et T la température qui est prise comme constante.

Un autre paramètre pouvant être utilisé pour caractériser le caractère compressible de la couche est le module d'élasticité isostatique (K). Il est appelé « bulk modulus » en anglais. Le module d'élasticité isostatique K est l'inverse du coefficient de compressibilité isotherme $\chi_T$ et mesure la résistance d'un matériau à la compression uniforme. K est directement relié au Module d'Young (E) et au coefficient de Poisson du matériau (v) par la relation suivante :

$$K = \frac{1}{3}\frac{E}{(1-2v)}$$

Un coefficient de compressibilité isotherme $\chi_T$ de $1.10^{-10}$ Pa$^{-1}$ correspond à un module d'élasticité isostatique K de 10 GPa.

Le module d'Young E du matériau de la couche poreuse compressible peut être inférieur ou égal à 18 GPa. Le coefficient de Poisson v du matériau de la couche poreuse compressible peut être inférieur ou égale à 0,2.

La première couche poreuse peut comporter un taux volumique de porosités supérieur ou égal à environ 10 % et/ou être composée de, ou comporter, au moins un matériau déformable élastiquement ayant un module d'Young inférieur ou égal à environ 20 GPa, et/ou au moins un matériau déformable plastiquement ayant une limite d'élasticité inférieure ou égale à environ 350 MPa. Le taux volumique de porosités correspond au rapport entre le volume occupé par les pores dans la couche poreuse compressible et le volume total de la couche poreuse compressible

Selon un mode de réalisation avantageux, la taille des pores de la première couche poreuse peut être inférieure ou égale à environ un dixième de l'épaisseur de la couche poreuse, et/ou être inférieure à la taille des particules susceptibles d'être présentes à l'interface de collage entre les deux éléments lors de la solidarisation par collage direct, c'est-à-dire des particules pouvant générer des défauts de collage. La taille des particules pouvant être présentes à l'interface de collage peut être mesurée et/ou calculée au préalable par des essais de collage entre les deux éléments à solidariser.

Le matériau de la première couche poreuse peut être choisi avantageusement tel que le taux volumique de porosités soit supérieur ou égal à environ 10 % et/ou que la taille des pores soit inférieure ou égale à environ 10 nm. Plus la taille des pores est petite, plus le matériau de la première couche poreuse sera facile à intégrer dans l'empilement et pourra être structuré par les techniques classiques de gravure. Par ailleurs, la taille des pores peut être inférieure à la taille des particules présentes à l'interface de collage. Pour obtenir une meilleure efficacité, l'épaisseur de la première couche poreuse peut être supérieure à la taille de ces particules.

Le premier élément et/ou le deuxième élément peut comporter un substrat ou une puce électronique. Le procédé est avantageusement mis en œuvre pour réaliser un collage direct entre deux substrats, ou entre deux puces électroniques, ou encore entre un substrat et une puce électronique.

Le procédé peut comporter en outre les étapes de :

- réalisation, sur au moins une face du deuxième élément, d'au moins une deuxième couche poreuse compressible,
- réalisation d'au moins une deuxième couche de collage sur la deuxième couche poreuse,

et dans lequel la solidarisation par collage direct du deuxième élément avec la première couche de collage peut être obtenue par une mise en contact direct de la première couche de collage contre la deuxième couche de collage.

Comme pour la première couche poreuse, la deuxième couche poreuse peut être réalisée via la mise en œuvre d'une étape de dépôt. Les mêmes avantages que ceux exposés précédemment pour la première couche poreuse se retrouve alors lorsque la deuxième couche poreuse est réalisée par dépôt.

La deuxième couche poreuse peut comporter un taux volumique de porosités supérieur ou égal à environ 10%, et/ou être composée de, ou comporter, au moins un matériau déformable élastiquement ayant un module d'Young inférieur ou égal à environ 20 GPa, et/ou au moins un matériau déformable plastiquement ayant une limite d'élasticité inférieure ou égale à environ 350 MPa.

La taille des pores de la deuxième couche poreuse peut être inférieure ou égale à environ un dixième de l'épaisseur de la deuxième couche poreuse, et/ou être inférieure à la taille des particules susceptibles d'être présentes à l'interface de collage entre les deux éléments lors de la solidarisation par collage direct.

Les différentes propriétés énoncées précédemment pour la première couche poreuse peuvent s'appliquer également à la deuxième couche poreuse.

La première couche poreuse peut comporter une épaisseur supérieure à l'épaisseur de la première couche de collage, et/ou la deuxième couche poreuse peut comporter une épaisseur supérieure à l'épaisseur de la deuxième couche de collage. Ainsi, on augmente le caractère compressible de la ou des couches poreuses afin d'atténuer au mieux les défauts générés par les particules présentes au niveau de l'interface de collage. L'épaisseur de la première couche de collage et/ou l'épaisseur de la deuxième couche de collage peut être inférieure à environ 50 nm.

La réalisation de la première couche poreuse et/ou la réalisation de la deuxième couche poreuse peut comporter au moins la mise en œuvre d'un dépôt PECVD (dépôt chimique en phase vapeur assisté par plasma) de SiOCH poreux. Dans ce cas, la première et/ou la deuxième couche poreuse peut présenter naturellement un caractère poreux.

La réalisation de la première couche poreuse et/ou la réalisation de la deuxième couche poreuse peut comporter un dépôt d'un matériau apte à être gravé et destiné à former la première couche poreuse et/ou la deuxième couche poreuse, puis la formation de pores par gravure chimique et/ou électrochimique dans le matériau déposé. Ainsi, une telle couche poreuse peut être obtenue par exemple par un dépôt d'une couche d'aluminium rendue poreuse par une gravure électrochimique, par exemple à travers une membrane nanoporeuse. Les pores peuvent être également générés par une oxydation anodique locale de l'aluminium.

La réalisation de la première couche poreuse et/ou la réalisation de la deuxième couche poreuse peut comporter au moins la mise en œuvre des étapes de :

- dépôt du matériau de la première couche poreuse et/ou de la deuxième couche poreuse, des particules porogènes étant ajoutées au dit matériau déposé, et
- élimination desdites particules porogènes, formant des pores au sein du matériau de la première couche poreuse et/ou de la deuxième couche poreuse.

Dans ce cas, le matériau de la première couche poreuse et/ou le matériau de la deuxième couche poreuse peut comporter du SiOCH et/ou du BCB (Benzocyclobutène) et/ou du polyimide. Le dépôt du matériau peut être réalisé par PECVD ou par étalement en fonction du matériau choisi.

La réalisation de la première couche de collage et/ou la réalisation de la deuxième couche de collage peut comporter une étape de dépôt du matériau de la première couche de collage sur la première couche poreuse et/ou une étape de dépôt du matériau de la deuxième couche de collage sur la deuxième couche poreuse.

En variante, la réalisation de la première couche de collage et/ou la réalisation de la deuxième couche de collage peut comporter une étape de traitement thermique, plasma ou chimique d'une partie de la première couche poreuse et/ou de la deuxième couche poreuse, ladite partie traitée de la première couche poreuse formant la première couche de collage et/ou ladite partie traitée de la deuxième couche poreuse formant la deuxième couche de collage.

Le procédé peut comporter en outre, entre l'étape de réalisation de la première couche de collage et l'étape de solidarisation par collage direct du deuxième élément avec la première couche de collage, la mise en œuvre des étapes de :

- photolithographie et gravure d'au moins un emplacement de plot de connexion à travers la première couche de collage, la première couche poreuse et une partie du premier élément,
- dépôt, au moins dans ledit emplacement, d'au moins un matériau électriquement conducteur formant le plot de connexion,
- planarisation mécano-chimique avec arrêt sur la première couche de collage,

et dans lequel, lors de la solidarisation par collage direct du deuxième élément avec la première couche de collage, le plot de connexion réalisé dans le premier élément peut être solidarisé par collage direct avec un plot de connexion réalisé dans le deuxième élément.

En variante, le procédé peut comporter en outre, avant l'étape de réalisation de la première couche poreuse, la mise en œuvre des étapes de :

- photolithographie et gravure, à travers une partie du premier élément, d'au moins un emplacement de plot de connexion,
- dépôt, au moins dans ledit emplacement, d'au moins un matériau électriquement conducteur formant le plot de connexion,

dans lequel la réalisation de la première couche poreuse peut comporter la mise en œuvre des étapes suivantes :

- dépôt de la première couche poreuse sur le premier élément et le plot de connexion,
- planarisation mécano-chimique de la première couche poreuse avec arrêt sur le plot de connexion,

et dans lequel, lors de la solidarisation par collage direct du deuxième élément avec la première couche de collage, le plot de connexion réalisé dans le premier élément est solidarisé par collage direct avec un plot de connexion réalisé dans le deuxième élément.

Le procédé peut comporter en outre, préalablement au dépôt du matériau électriquement conducteur dans ledit emplacement, un dépôt d'au moins une couche de matériau apte à former une barrière à la diffusion du matériau du plot de connexion, le matériau électriquement conducteur pouvant être déposé ensuite sur cette couche de matériau barrière.

Selon un mode de réalisation avantageux, le premier élément et/ou le deuxième élément peut comporter une couche de matériau diélectrique, l'étape de photolithographie et gravure pouvant être effectuée également à travers cette couche de matériau diélectrique, cette dernière pouvant être éliminée au moins en partie après l'étape de réalisation du plot de connexion.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1A et 1B représentent des étapes d'un procédé de collage direct selon un premier mode de réalisation,
- les figures 2A et 2B représentent des étapes d'un procédé de collage direct selon un deuxième mode de réalisation,
- les figures 3A à 3C représentent des étapes de réalisation d'un plot de connexion dans un élément selon un premier exemple de réalisation,
- les figures 4A à 4G représentent des étapes de réalisation d'un plot de connexion dans un élément selon un deuxième exemple de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

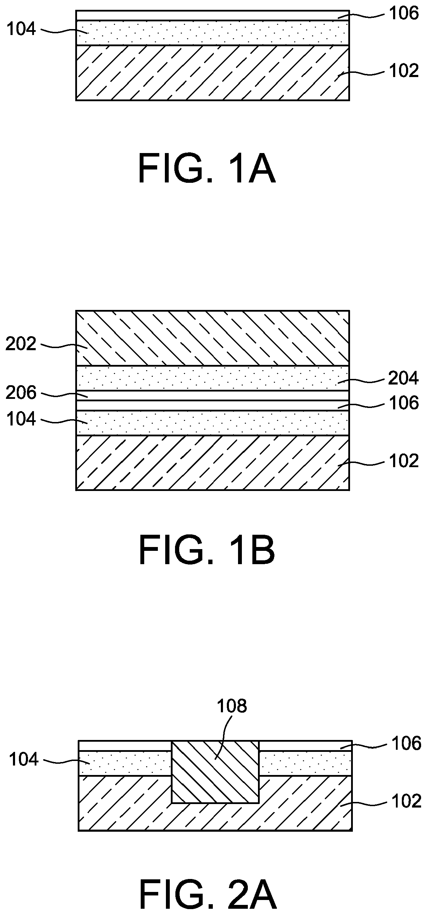

On décrit, en liaison avec les figures 1A et 1B, les étapes d'un procédé de collage direct entre deux éléments, ici deux substrats, selon un premier mode de réalisation.

Comme représenté sur la figure 1A, un premier substrat 102, ou premier wafer, par exemple composé de semi-conducteur tel que du silicium, est préparé afin de pouvoir être solidarisé par collage direct à un deuxième substrat 202, par exemple également composé de silicium. Pour cela, une première couche poreuse 104 est réalisée sur le premier substrat 102. Le matériau de la première couche poreuse 104 est réalisé tel qu'il présente un taux de porosités supérieur ou égale à environ 10 % et qu'il soit compressible, c'est-à-dire que ses propriétés d'élasticité et/ou de plasticité permettent une compression du matériau en présence d'une pression mécanique équivalente à celle générée par des particules pouvant être présentes à l'interface de collage avec le deuxième substrat 202. Pour cela, le module d'Young du matériau utilisé peut être inférieur ou égal à environ 20 GPa et/ou la limite élastique du matériau peut être inférieure ou égale à environ 350 MPa.

La première couche poreuse 104 peut être composée d'un matériau organique, par exemple du BCB dont le module d'Young est égal à environ 2,9 GPa, et/ou du polyimide dont le module d'Young est égal à environ 3,3 GPa. La première couche poreuse 104 peut également être composée d'un matériau minéral dopé avec des molécules organiques tel que du SiOCH poreux dont le module d'Young est égal à environ 5 GPa. La première couche poreuse 104 peut également être composée d'au moins un métal dont la limite élastique est suffisamment faible pour être compressible. Un tel métal peut être déposé par CVD (dépôt chimique en phase vapeur), PVD (dépôt physique en phase vapeur) ou par voie électrolytique (ECD), et peut être rendu poreux par gravure chimique et/ou électrochimique. Par exemple, la première couche poreuse 104 peut être composée d'aluminium rendu poreux par exemple par oxydation anodique.

De manière générale, l'épaisseur de la première couche poreuse 104 peut être comprise entre environ 100 nm et 5 μm.

Les porosités présentes dans le matériau de la première couche poreuse 104 peuvent être présentes naturellement dans le matériau utilisé pour former la couche 104, ou bien être créées lors de la réalisation de la première couche poreuse 104 lorsque le matériau utilisé ne comporte pas naturellement de telles porosités ou pour augmenter le taux de porosités du matériau.

Par exemple, la première couche poreuse 104 peut être composée de SiOCH et être déposée par PECVD ou par étalement (spin-on). Les porosités peuvent être générées naturellement en dopant une matrice de type silsesquioxane ou de type silice avec des groupements carbonés, méthyl CH3 par exemple. Les porosités peuvent également être générées en ajoutant des nanoparticules sacrificielles appelées porogènes. Dans le cas d'un dépôt par spin-on, l'addition de porogènes dans la couche se fait soit par dispersion de nanoparticules de porogène dans une solution de précurseur, soit par greffage de macromolécules au précurseur. La technique PECVD permet également de créer des porosités par substitution en utilisant par exemple un précurseur biphasé, par exemple un mélange de detetramethylcyclotetrasiloxane (TMCTS) avec une phase CHx thermiquement instable. Après libération du porogène ou de la phase instable par traitement thermique ou ultra-violet, un matériau poreux est obtenu. Des taux de porosités supérieurs à environ 50% sont possibles. La taille des pores est généralement de quelques nanomètres.

Des matériaux organiques de type BCB ou polyimide contenant des particules de porogènes peuvent également être utilisés. Ces particules porogènes correspondent par exemple à des matériaux organiques tels que des hydrocarbures. La taille des particules peut être comprise entre quelques nanomètres (moins de 10 nm) et quelques dizaines de nanomètres (moins de 100 nm). Ces particules sont ensuite éliminées, par exemple via un traitement UV ou un traitement thermique, libérant ainsi les espaces précédemment occupés par ces particules et formant les pores dans la première couche poreuse 104. Même lorsque le matériau de la première couche poreuse 104 présente naturellement des porosités (cas du SiOCH poreux par exemple), il est possible que des porosités supplémentaires soient réalisées dans le matériau déposé, en utilisant par exemple des particules porogènes comme précédemment décrit.

Afin de remplir pleinement son rôle de couche compressible, la première couche poreuse 104 est réalisée telle que son épaisseur soit supérieure à la taille des particules pouvant se trouver sur les surfaces à coller. Pour dimensionner la première couche poreuse 104, des essais préalables peuvent être réalisés pour déterminer à l'avance la taille maximale des particules qui pourront être présentes sur les surfaces à coller (cette taille dépendant notamment des matériaux utilisés, des techniques mises en œuvre, de l'équipement utilisé, etc.).

On réalise ensuite, sur la première couche poreuse 104, une première couche de collage 106 destinée à être solidarisée, lors d'une étape ultérieure de collage direct, au deuxième substrat 202.

La première couche de collage 106 peut être déposée, par exemple par PECVD (par exemple un dépôt de silice d'épaisseur comprise entre environ 10 nm et 100 nm), sur la première couche poreuse 104, ou bien être créée à partir d'une partie supérieure (partie opposée à celle en contact avec le premier substrat 102) de la première couche poreuse 104, par exemple via un traitement thermique, plasma ou chimique transformant cette partie supérieure de la première couche poreuse 104 en la première couche de collage 106. Par exemple, lorsque la première couche poreuse 104 est composée de SiOCH poreux, il est possible de réaliser, via un traitement plasma, en surface de la première couche poreuse 104 (c'est-à-dire dans une petite partie de l'épaisseur de la première couche poreuse 104, du côté opposé à celui en contact avec le premier substrat 102) une couche dense de SiOC en surface de la première couche poreuse 104, cette couche de SiOC correspondant à la première couche de collage 106. La première couche de collage 106 est réalisée telle que son épaisseur soit inférieure à celle de la première couche poreuse 104 afin que lors de la solidarisation par collage direct, la première couche poreuse 104 remplisse au mieux son rôle de couche compressible en réduisant l'impact des particules présentes à l'interface de collage. Avantageusement, la première couche de collage 106 comporte une épaisseur comprise entre environ 1 nm et 100 nm, ou inférieure à environ 50 nm.

Parallèlement à la réalisation de la première couche poreuse 104 et de la première couche de collage 106 sur le premier substrat 102, une deuxième couche poreuse 204, par exemple similaire à la première couche poreuse 104, et une deuxième couche de collage 206, pouvant également être similaire à la première couche de collage 106, sont réalisées sur le deuxième substrat 202 destiné à être solidarisé au premier substrat 102.

Un collage direct entre les couches de collage 106 et 206 est ensuite réalisé (figure 1B).

Comme lors de la réalisation d'un collage direct classique (sans la présence des couches poreuses 104 et 204), un traitement thermique peut être mis en œuvre afin de consolider ce collage. Lors de ce collage direct, si des particules sont présentes à l'interface entre les couches de collage 106 et 206, les couches poreuses 104 et 204 se déforment alors localement au niveau de ces particules, réduisant ainsi fortement la taille des zones non collées au niveau de cette interface. Comme pour un collage direct classique, un polissage mécano-chimique peut être utilisé pour réduire la rugosité de surface et activer la surface de collage. Dans ce cas, l'épaisseur de l'une ou des couches de collage (106 et/ou 206) doit prendre en compte la consommation de l'une ou des couches lors du polissage. En ajustant le temps de procédé, le polissage peut également être utilisé pour ajuster l'épaisseur de l'une ou des couches de collage avant l'étape de collage de façon à optimiser l'effet des couches compressives.

Le procédé de collage direct précédemment décrit en liaison avec les figures 1A et 1B peut également s'appliquer pour le collage direct de deux puces électroniques entre elles (les puces correspondant aux éléments 102 et 202 précédemment décrits) ou encore pour le collage direct d'une puce électronique et d'un substrat.

De plus, il est également possible qu'une seule des deux couches poreuses 104 et 204 soit réalisée. Par exemple, si seule la première couche poreuse 104 est réalisée, le deuxième élément 202 peut être solidarisé, directement ou via une couche de collage, contre la première couche de collage 106.

Des simulations numériques par éléments finis montrent que la taille d'une zone non collée autour d'une particule est réduite de moitié en insérant une couche poreuse dont l'épaisseur correspond sensiblement au rayon de la particule, dont le matériau présente un module d'Young d'environ 5 GPa et qui est enterrée sous une couche de collage composée de silice et d'épaisseur égale à environ 100 nm. La taille de la zone non collée peut être encore réduite lorsque l'épaisseur de la couche de collage est inférieure à environ 100 nm.

Un tel collage direct peut également être réalisé lorsque des plots de connexion, ou plots de contact, électriquement conducteurs sont présents au niveau des surfaces à solidariser par collage direct, ces plots étant destinés à former des interconnexions électriques entre les deux éléments solidarisés (substrats et/ou puces électroniques par exemple).

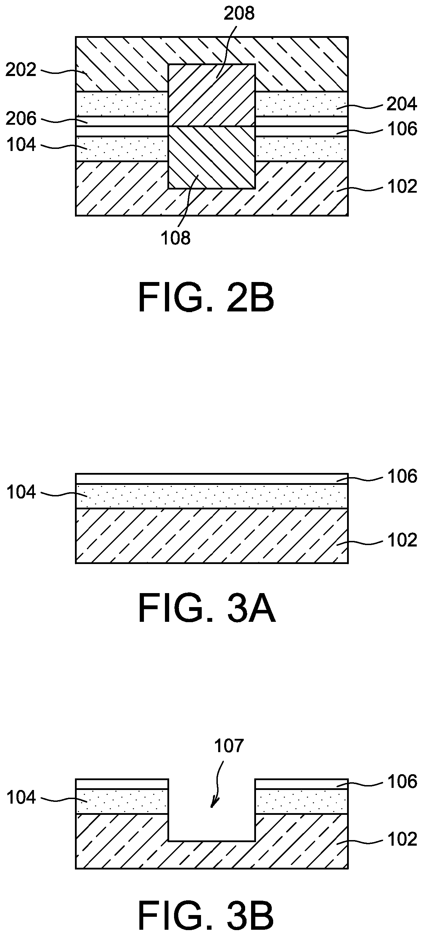

Ainsi, sur l'exemple de la figure 2A, un plot de connexion 108, ici métallique et par exemple composé de cuivre, est réalisé à travers les couches 104 et 106, ainsi que dans une partie du premier élément 102. Bien que non représentée sur la figure 2A, une couche barrière, par exemple composée de TiN et/ou de TaN, isole le plot 108 des couches 104 et 106 ainsi que du premier élément 102. Lors de la solidarisation du premier élément 102 au deuxième élément 202, le plot de connexion 108 est mis en contact direct avec un autre plot de connexion 208, par exemple de nature similaire au plot de connexion 108, réalisé à travers les couches 204 et 206 ainsi que dans une partie du deuxième élément 202 (voir figure 2B). Compte tenu de la présence des couches poreuses 104, 204, ce collage direct est peu sensible à la contamination particulaire présente sur les zones diélectriques autour des plots de connexion 108 et 208, c'est-à-dire aux particules présentes sur les parties des couches de collage 106, 206 en contact l'une avec l'autre. Un tel collage direct peut être réalisé lorsque les plots de connexion 108 et 208 sont composés de tout matériau compatible avec un tel collage direct, comme par exemple du cuivre et/ou du nickel. Bien qu'un seul plot de connexion 108, 208 soit représenté pour chaque élément 102, 202, plusieurs plots de connexion peuvent être réalisés dans chacun des éléments 102, 202. Les particules présentes entre les plots 108 et 208 lors du collage ne bénéficient pas de la présence des couches poreuses 104 et 204. Par contre, les défauts de collage générés par ces particules entre les plots métalliques 108, 208 peuvent bénéficier du recuit de consolidation qui peut permettre une « réparation » partielle de ces défauts lors de la recristallisation de l'interface métallique.

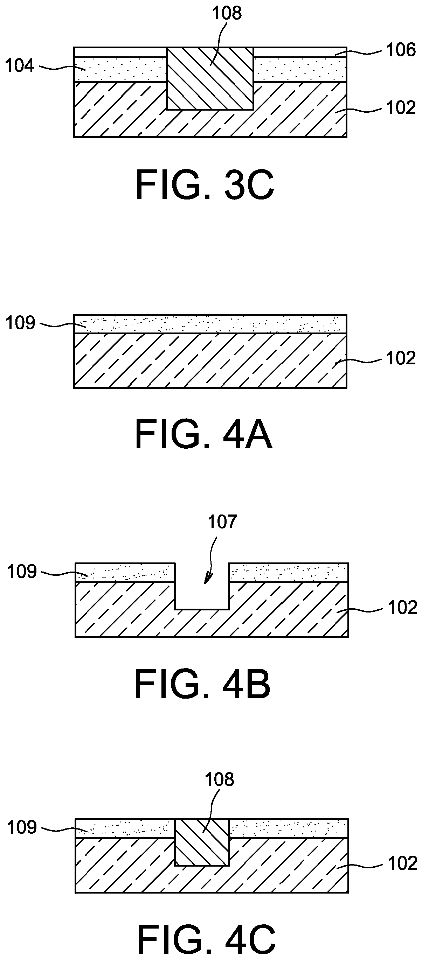

Les plots de connexion peuvent être réalisés par voie dite « damascène », comme représenté par exemple sur les figures 3A à 3C. Les emplacements du ou des plots de connexion sont tout d'abord formés par photolithographie et gravure dans l'empilement des couches 104 et 106 et dans le premier élément 102, formant des emplacements 107 des futurs plots de connexion 108 (figure 3B). Une couche de matériau apte à former une barrière de diffusion vis-à-vis du matériau des plots de connexion 108 est déposée en recouvrant les parois (paroi de fond et parois latérales) des emplacements 107, ainsi que la couche de collage 106. L'épaisseur de cette couche barrière est par exemple comprise entre environ 10 nm et 50 nm. Le matériau des plots de connexion 108 (ici du cuivre) est ensuite déposé sur le matériau barrière, en remplissant notamment les emplacements 107. L'excès de matériau de la couche barrière et des plots de connexion 108 est ensuite éliminé par exemple par polissage mécano-chimique avec arrêt sur la couche de collage 106 (figure 3C). Le ou les plots de connexion 208 peuvent être réalisés en mettant en œuvre les mêmes étapes que celles formant le ou les plots de connexion 108.

Un deuxième exemple de réalisation des plots de connexion 108 est représenté sur les figures 4A à 4G.

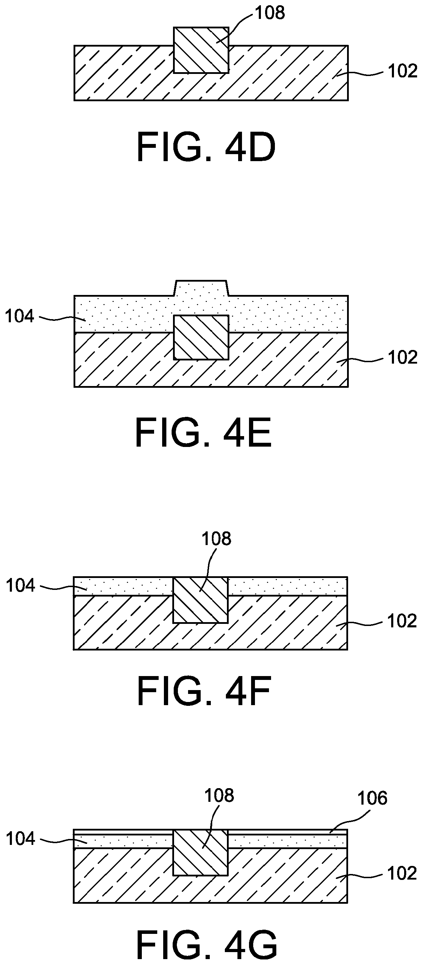

On réalise tout d'abord, sur le premier substrat 102, le dépôt d'une couche de matériau sacrificiel 109 (figure 4A). Une photolithographie et une gravure de la couche de matériau sacrificiel 109 permettent de définir les futurs emplacements des plots de connexion dans la couche de matériau sacrificiel 109, qui forme alors un masque de gravure. Le premier élément 102 est ensuite gravé selon le motif de ce masque de gravure, formant ainsi les emplacements 107 des plots de connexion 108 (figure 4B). Comme représenté sur la figure 4C, le ou les emplacements 107 sont remplis par du matériau électriquement conducteur (éventuellement précédé du dépôt d'une couche barrière), formant ainsi le ou les plots de connexion 108. Une gravure sélective est ensuite réalisée pour supprimer la couche de matériau sacrificiel 109 (figure 4D). On dépose ensuite de manière conforme la première couche poreuse 104 (figure 4E), cette couche étant ensuite poli par CMP avec arrêt sur le plot de connexion 108 (Figure 4F). Enfin, on réalise la première couche de collage 106, en transformant par exemple via un traitement plasma, une partie supérieure de la première couche poreuse 104 (Figure 4G). Le plot de connexion 208 peut être réalisé de manière analogue à celle précédemment décrite en liaison avec les figures 4A à 4G, ou bien de la manière décrite en liaison avec les figures 3A à 3C.

## Revendications

1. Procédé de collage direct entre un premier élément (102) et un deuxième élément (202), comportant au moins les étapes de :

   - dépôt d'au moins une première couche poreuse (104) sur au moins une face du premier élément (102),
   - réalisation d'au moins une première couche de collage (106) sur la première couche poreuse (104) et
   - solidarisation par collage direct du deuxième élément (202) avec la première couche de collage (106), **caractérisé par** la première couche poreuse étant compressible et présentant un coefficient de compressibilité isotherme $\chi_T$ supérieur à $10^{-10}$ $Pa^{-1}$ à 25°C.

2. Procédé selon la revendication 1, dans lequel la première couche poreuse (104) comporte un taux volumique de porosités supérieur ou égal à environ 10 %, et/ou comporte au moins un matériau déformable élastiquement ayant un module d'Young inférieur ou égal à environ 20 GPa, et/ou au moins un matériau déformable plastiquement ayant une limite d'élasticité inférieure ou égale à environ 350 MPa.

3. Procédé selon l'une des revendications précédentes, dans lequel la tailles des pores de la première couche poreuse (104) est inférieure ou égale à environ un dixième de l'épaisseur de la première couche poreuse (104), et/ou est inférieure à la taille des particules susceptibles d'être présentes à l'interface de collage entre les deux éléments (102, 202) lors de la solidarisation par collage direct.

4. Procédé selon l'une des revendications précédentes, dans lequel le premier élément (102) et/ou le deuxième élément (202) comporte un substrat ou une puce électronique.

5. Procédé selon l'une des revendications précédentes, comportant en outre les étapes de :

   - réalisation, sur au moins une face du deuxième élément (202), d'au moins une deuxième couche poreuse (204) compressible, présentant un coefficient de compressibilité isotherme $\chi_T$ supérieur à $10^{-10}$ Pa$^{-1}$ à 25°C.
   - réalisation d'au moins une deuxième couche de collage (206) sur la deuxième couche poreuse (204),

   et dans lequel la solidarisation par collage direct du deuxième élément (202) avec la première couche de collage (106) est obtenue par une mise en contact direct de la première couche de collage (106) contre la deuxième couche de collage (206).

6. Procédé selon la revendication 5, dans lequel la deuxième couche poreuse (204) comporte un taux volumique de porosités supérieur ou égal à environ 10 %, et/ou comporte au moins un matériau déformable élastiquement ayant un module d'Young inférieur ou égal à environ 20GPa, et/ou au moins un matériau déformable plastiquement ayant une limite d'élasticité inférieure ou égale à environ 350 MPa.

7. Procédé selon l'une des revendications précédentes, dans lequel la première couche poreuse (104) comporte une épaisseur supérieure à l'épaisseur de la première couche de collage (106), et/ou la deuxième couche poreuse (204) comporte une épaisseur supérieure à l'épaisseur de la deuxième couche de collage (206).

8. Procédé selon l'une des revendications précédentes, dans lequel le dépôt de la première couche poreuse (104) et/ou la réalisation de la deuxième couche poreuse (204) comporte au moins la mise en œuvre d'un dépôt PECVD de SiOCH poreux.

9. Procédé selon l'une des revendications précédentes, dans lequel le dépôt de la première couche poreuse (104) et/ou la réalisation de la deuxième couche poreuse (204) comporte un dépôt d'un matériau apte à être gravé et destiné à former la première couche poreuse (104) et/ou la deuxième couche poreuse (204), puis la formation de pores par gravure chimique dans le matériau déposé.

10. Procédé selon l'une des revendications précédentes, dans lequel le dépôt de la première couche poreuse (104) et/ou la réalisation de la deuxième couche poreuse (204) comporte au moins la mise en œuvre des étapes de :

    - dépôt du matériau de la première couche poreuse (104) et/ou de la deuxième couche poreuse (204), des particules porogènes étant ajoutées au dit matériau déposé, et
    - élimination desdites particules porogènes, formant des pores au sein du matériau de la première couche poreuse (104) et/ou de la deuxième couche poreuse (204).

11. Procédé selon la revendication 10, dans lequel le matériau de la première couche poreuse (104) et/ou le matériau de la deuxième couche poreuse (204) comporte du SiOCH.

12. Procédé selon l'une des revendications précédentes, dans lequel la réalisation de la première couche de collage (106) et/ou la réalisation de la deuxième couche de collage (206) comporte une étape de dépôt du matériau de la première couche de collage (106) sur la première couche poreuse (104) et/ou une étape de dépôt du matériau de la deuxième couche de collage (206) sur la deuxième couche poreuse (204).

13. Procédé selon l'une des revendications 1 à 11, dans lequel la réalisation de la première couche de collage (106) et/ou la réalisation de la deuxième couche de collage (206) comporte une étape de traitement thermique, plasma ou chimique d'une partie de la première couche poreuse (104) et/ou de la deuxième couche poreuse (204), ladite partie traitée de la première couche poreuse formant la première couche de collage (106) et/ou ladite partie traitée de la deuxième couche poreuse formant la deuxième couche de collage (206).

14. Procédé selon l'une des revendications précédentes, comportant en outre, entre l'étape de réalisation de la première couche de collage et l'étape de solidarisation par collage direct du deuxième élément avec la première couche de collage, la mise en œuvre des étapes de :

    - photolithographie et gravure d'au moins un emplacement (107) de plot de connexion à travers la première couche de collage (106), la première couche poreuse (104) et une partie du premier élément (102),

- dépôt, au moins dans ledit emplacement (107), d'au moins un matériau électriquement conducteur formant le plot de connexion (108),
- planarisation mécano-chimique avec arrêt sur la première couche de collage (106),

et dans lequel, lors de la solidarisation par collage direct du deuxième élément (202) avec la première couche de collage (106), le plot de connexion (108) réalisé dans le premier élément (102) est solidarisé par collage direct avec un plot de connexion (208) réalisé dans le deuxième élément (202).

15. Procédé selon l'une des revendications 1 à 13, comportant en outre, avant l'étape de réalisation de la première couche de collage (106), la mise en œuvre des étapes de :

   - photolithographie et gravure, à travers une partie du premier élément (102), d'au moins un emplacement (107) de plot de connexion,
   - dépôt, au moins dans ledit emplacement (107), d'au moins un matériau électriquement conducteur formant le plot de connexion (108),

   dans lequel la réalisation de la première couche poreuse (104) comporte la mise en œuvre des étapes suivantes :

   - dépôt de la première couche poreuse (104) sur le premier élément (102) et le plot de connexion (108),
   - planarisation mécano-chimique de la première couche poreuse (104) avec arrêt sur le plot de connexion (108),

   et dans lequel, lors de la solidarisation par collage direct du deuxième élément (202) avec la première couche de collage (106), le plot de connexion (108) réalisé dans le premier élément (102) est solidarisé par collage direct avec un plot de connexion (208) réalisé dans le deuxième élément (202).

16. Procédé selon l'une des revendications 14 ou 15, comportant en outre, préalablement au dépôt du matériau électriquement conducteur dans ledit emplacement, un dépôt d'au moins une couche de matériau apte à former une barrière à la diffusion du matériau du plot de connexion, le matériau électriquement conducteur étant déposé ensuite sur cette couche de matériau barrière.

**Patentansprüche**

1. Verfahren zum direkten Bonden zwischen einem ersten Element (102) und einem zweiten Element (202), umfassend zumindest die folgenden Schritte:

   - Abscheiden zumindest einer ersten porösen Schicht (104) auf zumindest einer Seite des ersten Elements (102),
   - Herstellen zumindest einer ersten Bondschicht (106) auf der ersten porösen Schicht (104), und
   - Verbinden des zweiten Elements (202) mit der ersten Bondschicht (106) durch direktes Bonden, **dadurch gekennzeichnet, dass** die erste poröse Schicht komprimierbar ist und einen isothermen Kompressibilitätskoeffizienten $\chi_T$ von über $10^{-10}$ Pa$^{-1}$ bei 25 °C aufweist.

2. Verfahren nach Anspruch 1, wobei die erste poröse Schicht (104) ein Porositäts-Volumenverhältnis größer oder gleich etwa 10 % aufweist und/oder zumindest ein elastisch verformbares Material mit einem Elastizitätsmodul kleiner oder gleich etwa 20 GPa und/oder zumindest ein plastisch verformbares Material mit einer Streckgrenze kleiner oder gleich etwa 350 MPa aufweist.

3. Verfahren nach einem der vorangehenden Ansprüche, wobei die Porengröße der ersten porösen Schicht (104) kleiner oder gleich etwa einem Zehntel der Dicke der ersten porösen Schicht (104) ist und/oder kleiner ist als die Größe der Partikel, die an der Bondgrenzfläche zwischen den beiden Elementen (102, 202) bei der Verbindung durch direktes Bonden vorhanden sein können.

4. Verfahren nach einem der vorangehenden Ansprüche, wobei das erste Element (102) und/oder das zweite Element (202) ein Substrat oder einen elektronischen Chip enthält.

5. Verfahren nach einem der vorangehenden Ansprüche, wobei es ferner die folgenden Schritte umfasst:

   - Herstellen zumindest einer zweiten komprimierbaren porösen Schicht (204) auf zumindest einer Seite des zweiten Elements (202), die einen isothermen Kompressibilitätskoeffizienten $\chi_T$ von über $10^{-10}$ Pa$^{-1}$ bei 25 °C aufweist,
   - Herstellen zumindest einer zweiten Bondschicht (206) auf der zweiten porösen Schicht (204),

   wobei die Verbindung durch direktes Bonden des zweiten Elements (202) mit der ersten Bondschicht (106) durch direktes Kontaktieren der ersten Bondschicht (106) mit der zweiten Bondschicht (206) erhalten wird.

6. Verfahren nach Anspruch 5, wobei die zweite poröse Schicht (204) ein Porositäts-Volumenverhältnis größer oder gleich etwa 10 % aufweist und/oder zumindest ein elastisch verformbares Material mit einem Elastizitätsmodul kleiner oder gleich etwa 20 GPa und/oder zumindest ein plastisch verformbares Material mit einer Streckgrenze kleiner oder gleich etwa 350 MPa aufweist.

7. Verfahren nach einem der vorangehenden Ansprüche, wobei die erste poröse Schicht (104) eine Dicke aufweist, die größer ist als die Dicke der ersten Bondschicht (106), und/oder die zweite poröse Schicht (204) eine Dicke aufweist, die größer ist als die Dicke der zweiten Bondschicht (206).

8. Verfahren nach einem der vorangehenden Ansprüche, wobei das Abscheiden der ersten porösen Schicht (104) und/oder das Herstellen der zweiten porösen Schicht (204) zumindest die Durchführung einer PECVD-Abscheidung von porösem SiOCH umfasst.

9. Verfahren nach einem der vorangehenden Ansprüche, wobei das Abscheiden der ersten porösen Schicht (104) und/oder das Herstellen der zweiten porösen Schicht (204) ein Abscheiden eines ätzbaren Materials zur Bildung der ersten porösen Schicht (104) und/oder der zweiten porösen Schicht (204) und dann das Bilden von Poren durch chemisches Ätzen in dem abgeschiedenen Material umfasst.

10. Verfahren nach einem der vorangehenden Ansprüche, wobei das Abscheiden der ersten porösen Schicht (104) und/oder das Herstellen der zweiten porösen Schicht (204) zumindest das Ausführen der folgenden Schritte umfasst:

   - Abscheiden des Materials der ersten porösen Schicht (104) und/oder der zweiten porösen Schicht (204), wobei dem abgeschiedenen Material porenbildende Partikel zugesetzt werden, und
   - Entfernen der porenbildenden Partikel, wodurch Poren innerhalb des Materials der ersten porösen Schicht (104) und/oder der zweiten porösen Schicht (204) gebildet werden.

11. Verfahren nach Anspruch 10, wobei das Material der ersten porösen Schicht (104) und/oder das Material der zweiten porösen Schicht (204) SiOCH enthält.

12. Verfahren nach einem der vorangehenden Ansprüche, wobei das Herstellen der ersten Bondschicht (106) und/oder das Herstellen der zweiten Bondschicht (206) einen Schritt des Abscheidens des Materials der ersten Bondschicht (106) auf der ersten porösen Schicht (104) und/oder einen Schritt des Abscheidens des Materials der zweiten Bondschicht (206) auf der zweiten porösen Schicht (204) umfasst.

13. Verfahren nach einem der Ansprüche 1 bis 11, wobei das Herstellen der ersten Bondschicht (106) und/oder das Herstellen der zweiten Bondschicht (206) einen Schritt der Wärme-, Plasma- oder chemischen Behandlung eines Teils der ersten porösen Schicht (104) und/oder der zweiten porösen Schicht (204) umfasst, wobei der behandelte Teil der ersten porösen Schicht die erste Bondschicht (106) bildet und/oder der behandelte Teil der zweiten porösen Schicht die zweite Bondschicht (206) bildet.

14. Verfahren nach einem der vorangehenden Ansprüche, ferner umfassend zwischen dem Schritt des Herstellens der ersten Bondschicht und dem Schritt des Verbindens durch direktes Bonden des zweiten Elements mit der ersten Bondschicht das Ausführen der folgenden Schritte:

   - Photolithographie und Ätzen von zumindest einer Anschlussstückstelle (107) durch die erste Bondschicht (106), die erste poröse Schicht (104) und einen Teil des ersten Elements (102) hindurch,
   - Abscheiden von zumindest einem elektrisch leitenden Material, das das Anschlussstück (108) bildet, zumindest an dieser Stelle (107),
   - chemisch-mechanisches Planarisieren mit Anhalten an der ersten Bondschicht (106),

   und wobei beim Verbinden durch direktes Bonden des zweiten Elements (202) mit der ersten Bondschicht (106) das in dem ersten Element (102) ausgebildete Anschlussstück (108) mit einem in dem zweiten Element (202) ausgebildeten Anschlussstück (208) durch direktes Bonden verbunden wird.

15. Verfahren nach einem der Ansprüche 1 bis 13, ferner umfassend vor dem Schritt des Herstellens der ersten Bondschicht (106) das Ausführen der folgenden Schritte:

   - Photolithographie und Ätzen von zumindest einer Anschlussstückstelle (107) durch einen Teil des ersten Elements (102) hindurch,
   - Abscheiden von zumindest einem elektrisch leitenden Material, das das Anschlussstück (108) bildet, zumindest an dieser Stelle (107),

   wobei das Herstellen der ersten porösen Schicht (104) das Ausführen der folgenden Schritte umfasst:

   - Abscheiden der ersten porösen Schicht (104) auf dem ersten Element (102) und dem Anschlussstück (108),
   - chemisch-mechanisches Planarisieren der ersten porösen Schicht (104) mit Anhalten am Anschlussstück (108),

   und wobei beim Verbinden durch direktes Bonden des zweiten Elements (202) mit der ersten Bondschicht (106) das in dem ersten Element (102) ausgebildete Anschlussstück (108) mit einem in dem zweiten Element (202) ausgebildeten Anschlussstück (208) durch direktes Bonden verbunden wird.

16. Verfahren nach einem der Ansprüche 14 oder 15, ferner umfassend vor dem Abscheiden des elektrisch leitenden Materials an der genannten Stelle ein Abscheiden zumindest einer Materialschicht, die dazu geeignet ist, eine Barriere für die Diffusion des Materials des Anschlussstücks zu bilden, wobei das elektrisch leitende Material dann auf dieser Barrierematerialschicht abgeschieden wird.

**Claims**

1. Method for direct bonding between a first element (102) and a second element (202), including at least the following steps:

   - deposition of at least one first porous layer (104) on at least one face of the first element (102),
   - production of at least one first bonding layer (106) on the first porous layer (104) and
   - rigid connection by direct bonding of the second element (202) with the first bonding layer (106), **characterized by** the first porous layer (104) being compressible and having an isothermal compressibility coefficient $\chi_T$ greater than $10^{-10}$ Pa$^{-1}$ at 25°C.

2. Method according to claim 1, in which the first porous layer (104) has a void volume ratio greater than or equal to approximately 10% and/or includes at least one elastically deformable material having a Young modulus of less than or equal to approximately 20 GPa, and/or at least one plastically deformable material having an elastic limit of less than or equal to approximately 350 MPa.

3. Method according to one of previous claims, in which the size of the pores of the first porous layer (104) is less than or equal to approximately one tenth the thickness of the first porous layer (104), and/or is less than the size of the particles likely to be present at the bonding interface between the two elements (102, 202) when a rigid connection by direct bonding is made.

4. Method according to one of previous claims, in which the first element (102) and/or the second element (202) includes a substrate or an electronic chip.

5. Method according to one of previous claims, also including the following steps:

   - production, on at least one face of the second element (202), of at least one second compressible porous layer (204) having an isothermal compressibility coefficient $\chi_T$ greater than $10^{-10}$ Pa$^{-1}$ at 25°C,
   - production of at least one second bonding layer (206) on the second porous layer (204),

   and in which a rigid connection by direct bonding of the second element (202) with the first bonding layer (106) is obtained by bringing the first bonding layer (106) directly into contact with the second bonding layer (206).

6. Method according to claim 5, in which the second porous layer (204) has a void volume ratio greater than or equal to approximately 10% and/or includes at least one elastically deformable material having a Young modulus of less than or equal to approximately 20 GPa, and/or at least one plastically deformable material having an elastic limit of less than or equal to approximately 350 MPa.

7. Method according to one of previous claims, in which the first porous layer (104) is thicker than the first bonding layer (106), and/or the second porous layer (204) is thicker than the second bonding layer (206).

8. Method according to one of previous claims, in which the deposition of the first porous layer (104) and/or the production of the second porous layer (204) includes at least use of a PECVD deposition of porous SiOCH.

9. Method according to one of previous claims, in which the deposition of the first porous layer (104) and/or the production of the second porous layer (204) includes a deposition of a material able to be etched and intended to form the first porous layer (104) and/or the second porous layer (204), followed by formation of pores by chemical etching in the deposited material.

10. Method according to one of previous claims, in which the deposition of the first porous layer (104) and/or the production of the second porous layer (204) includes at least use of the following steps:

    - deposition of the material of the first porous layer (104) and/or of the second porous layer (204), where the pore-forming particles are added to the said deposited material, and
    - elimination of the said pore-forming particles, forming pores within the material of the first porous layer (104) and/or of the second porous layer (204).

11. Method according to claim 10, in which the material of the first porous layer (104) and/or the material of the second porous layer (204) includes SiOCH.

12. Method according to one of previous claims, in which the production of the first bonding layer (106) and/or the production of the second bonding layer (206) includes a step of deposition of the material of the first bonding layer (106) on the first porous layer (104) and/or a step of deposition of the material of the second bonding layer (206) on the second porous layer (204).

13. Method according to one of claims 1 to 11, in which the production of the first bonding layer (106) and/or the production of the second bonding layer (206) includes a step of thermal, plasma or chemical treatment of a part of the first porous layer (104) and/or of the second porous layer (204), said treated part of the first porous layer forming the first bonding layer (106) and/or said treated part of the second porous layer forms the second bonding layer (206).

14. Method according to one of previous claims, also including, between the step of production of the first bonding layer and the step of rigid connection by direct bonding of the second element with the first bonding layer, implementation of the following steps:

    - photolithography and etching of at least one bonding pad location (107) through the first bonding layer (106), the first porous layer (104) and a part of the first element (102),
    - deposition, at least in the said location (107), of at least one electrically conductive material forming the bonding pad (108),
    - chemical mechanical planarization, stopping on the first bonding layer (106),

    and in which, when the second element (202) is rigidly connected by direct bonding with the first bonding layer (106), the bonding pad (108) produced in the first element (102) is rigidly connected by direct bonding with a bonding pad (208) produced in the second element (202).

15. Method according to one of claims 1 to 13, also including, before the step of production of the first bonding layer (106), implementation of the following steps:

    - photolithography and etching, through a part of the first element (102), of at least one bonding pad location (107),
    - deposition, at least in the said location (107), of at least one electrically conductive material forming the bonding pad (108),

    in which production of the first porous layer (104) includes implementation of the following steps:

    - deposition of the first porous layer (104) on the first element (102) and the bonding pad (108),
    - chemical mechanical planarization of the first porous layer (104), stopping on the bonding pad (108),

and in which, when the second element (202) is rigidly connected by direct bonding with the first bonding layer (106), the bonding pad (108) produced in the first element (102) is rigidly connected by direct bonding with a bonding pad (208) produced in the second element (202).

16. Method according to one of claims 14 or 15, also including, prior to the deposition of the electrically conductive material in the said location, deposition of at least one layer of material capable of forming a barrier to diffusion of the material of the bonding pad, where the electrically conductive material is subsequently deposited on this layer of barrier material.

104 — 106

102

# FIG. 1A

202

206 — 204
104 — 106

102

# FIG. 1B

108

104 — 106

102

# FIG. 2A

208

202

206

104

108

204

106

102

# FIG. 2B

104

106

102

# FIG. 3A

107

104

106

102

# FIG. 3B

108

104 — 106

102

## FIG. 3C

109 — 102

## FIG. 4A

107

109 — 102

## FIG. 4B

108

109 — 102

## FIG. 4C

108

102

## FIG. 4D

104

102

## FIG. 4E

108

104

102

## FIG. 4F

108    106

104

102

## FIG. 4G

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 0554795 A1
- EP 0553774 A1
- EP 0851513 A2
- EP 2154710 A2

### Littérature non-brevet citée dans la description

- **DE Y. BERTHOLET et al.** Molecular bonding aided by dissipative inter-layers. *Acta Materiala,* Janvier 2007, vol. 55 (2), 473-479